# EUROPEAN PATENT APPLICATION

(11) **EP 4 203 641 A1**
(43) Date of publication of application: **28.06.2023**
(21) Application number: 22205746.5
(22) Date of filing: 07.11.2022
(51) Int. Cl.: H10B 10/00, H01L 21/8234, H01L 29/423, H01L 29/66, H01L 29/775, H01L 29/786

(54) **SRAM WITH DIPOLE DOPANT THRESHOLD VOLTAGE MODULATION FOR GREATER READ STABILITY**

(30) Priority: 23.12.2021 US 202117560927
(71) Applicant: INTEL Corporation, Santa Clara, CA 95054 (US)
(72) Inventor: ONG, Clifford, Portland, 97229 (US); LAVRIC, Dan, Portland, 97229 (US); GULER, Leonard, Hillsboro, 97124 (US); CHIU Yen Ting, Portland, 97229 (US); SHRIDHARAN, Smita, Hillsboro, 97124 (US); GUO, Zheng, Hillsboro, 97124 (US); KARL, Eric A., Portland, 97209 (US); GHANI, Tahir, Portland, 97229 (US)
(74) Representative: Goddar, Heinz J.

(57) **Abstract**

Integrated circuit (IC) static random-access memory (SRAM) comprising pass-gate transistors (292) and pull-down transistors (291) having different threshold voltages (Vt). A pass-gate transistor with a higher Vt than the pull-down transistor may reduce read instability of a bit-cell, and/or reduce overhead associated with read assist circuitry coupled to the bit-cell. In some examples, a different amount of a dipole dopant source material is deposited as part of the gate insulator for the pull-down transistor than for the pass-gate transistor, reducing the Vt of the pull-down transistor accordingly. In some examples, an N-dipole dopant source material is removed from the pass-gate transistor prior to a drive/activation anneal is performed. After drive/activation, the N-dipole dopant source material may be removed from the pull-down transistor and a same gate metal deposited over both the pass-gate and pull-down transistors.

## Description

### BACKGROUND

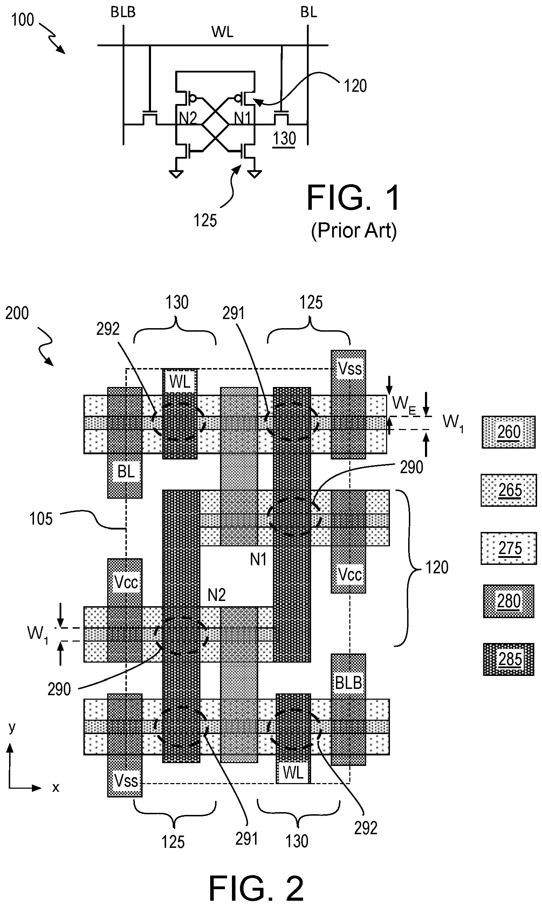

Integrated circuit (IC) devices often include static random-access memory (SRAM). Microprocessor chips, for example, dedicate a significant amount of chip area to SRAM arrays as a lowest level cache storing bits for processing by arithmetic logic units (ALUs). An SRAM array includes a plurality of SRAM bit cells. FIG. 1 illustrates a conventional six-transistor (6T) SRAM bit-cell 100 that includes six transistors comprising two p-channel load or "pull-up" transistors 120 and four n-channel transistors that further comprise two drive or "pull-down" transistors 125 and two pass-gate transistors 130.

During operation of bit-cell 100, when a bitline (BL) is driven to Vcc and bitline bar (BLB) is drive to Vss, inverter node N1 is exposed to BLB, which can induce a read disturbance. Accordingly, many SRAM implementations include read assist circuitry (not depicted in FIG. 1) coupled to SRAM bit-cell 100. Such read assist circuitry may have various topologies but is generally operable to lower the wordline (WL) voltage, and thereby weaken the N1 node exposure to BL/BLB. Such read assist circuitry can occupy significant chip area. Accordingly, improvements to an SRAM bit-cell architecture that can reduce the overhead of SRAM read assist circuitry is advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a circuit schematic of a conventional 6T-SRAM bit-cell;
FIG. 2 is a plan view of a 6T-SRAM bit-cell layout with dipole dopant Vt modulation between a pull-down and pass-gate transistors, in accordance with some embodiments;
FIG. 3 is an isometric sectional view further illustrating pull-down and pass-gate transistors with a gate-all-around stacked nanoribbon structure, in accordance with some nanoribbon embodiments;
FIG. 4A is a longitudinal cross-sectional view through the pass-gate and pull-down transistors shown in FIG. 3, in accordance with some embodiments;
FIG. 4B is a transverse cross-sectional view through a channel region of the pull-down transistor shown in FIG. 3, in accordance with some embodiments;
FIG. 4C is a transverse cross-sectional view through a channel region of the pass-gate transistor shown in FIG. 3, in accordance with some embodiments;
FIG. 5 is a flow diagram illustrating a method of fabricating an SRAM bit-cell with dipole dopant Vt modulation, in accordance with some embodiments;
FIG. 6 is a flow diagram illustrating a method for dipole dopant Vt modulation, in accordance with some embodiments;
FIG. 7A, 7B, 7C and 7D illustrate cross-sectional views of a pull-down transistor structure and a pass-gate transistor structure evolving as the methods illustrated in FIG. 6 are practiced, in accordance with some embodiments;
FIG. 8 is a flow diagram illustrating a method for dipole dopant Vt modulation, in accordance with some alternative embodiments;
FIG. 9A, 9B, 9C and 9D illustrate cross-sectional views of a pull-down transistor structure and a pass-gate transistor structure evolving as the methods illustrated in FIG. 8 are practiced, in accordance with some embodiments;
FIG. 10 illustrates a mobile computing platform and a data server machine employing an IC that includes an SRAM with dipole dopant modulated threshold voltages, in accordance with some embodiments; and
FIG. 11 is a functional block diagram of an electronic computing device, in accordance with some embodiments.

### DETAILED DESCRIPTION

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

The term "adjacent" here generally refers to a position of a thing being next to (e.g., immediately next to or close to with one or more things between them) or adjoining another thing (e.g., abutting it).

As used in the description and the appended claims, the singular forms "a", "an" and "the" are intended to include the plural forms as well, unless the context clearly indicates otherwise. It will also be understood that the term "and/or" as used herein refers to and encompasses any possible combinations of one or more of the associated listed items.

The terms "coupled" and "connected," along with their derivatives, may be used herein to describe functional or structural relationships between components. These terms are not intended as synonyms for each other. Rather, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

The term "signal" may refer to at least one current signal, voltage signal, magnetic signal, or data/clock signal.

As used throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

As used throughout this description, and in the claims, a list of items joined by the term "at least one of' or "one or more of' can mean any combination of the listed terms.

Unless otherwise specified in the explicit context of their use, the terms "substantially equal," "about equal" or "approximately equal" mean that there is no more than incidental variation between two things so described. In the art, such variation is typically no more than +/-10% of a predetermined target value.

In accordance with embodiments herein, integrated circuit (IC) static random-access memory (SRAM) comprises access or pass-gate transistors with a different threshold voltage (Vt) than pull-down transistors. For exemplary embodiments where pass-gate transistors have a higher Vt than pull-down transistors, drive current of the pass-gate transistors is reduced relative to that of the pull-down transistors for a reference bit-cell design where pull-down and pass-gate transistor architectures are otherwise substantially identical. Accordingly, read instability of a bit-cell, and/or overhead associated with read assist circuitry that would otherwise be needed to modulate the wordline voltage, may be reduced.

FIG. 2 is a plan view of a 6T-SRAM bit-cell layout 200 with a dipole dopant-based threshold voltage modulation or contrast between pull-down transistor 125 and pass-gate transistor 130, in accordance with some embodiments. Pull-down transistor 125 includes a gate insulator 291 surrounding a channel region of nanoribbons 260. Pass-gate transistor 130 includes a gate insulator 292 surrounding a channel region of nanoribbons 260. Gate insulator 291 includes an amount of a Vt-shifting dipole dopant that differs from an amount of Vt-shifting dipole dopant within gate insulator 292. Dipole dopant threshold voltage modulation between the two transistors may be utilized, for example, to lower the threshold voltage of the pull-down transistor relative to that of the pass-gate transistor.

In some exemplary embodiments where the Vt-shifting dipole dopant is an N-dipole dopant that reduces the magnitude of transistor threshold voltage of an NMOS transistor, an amount of the Vt-shifting N-dipole dopant within gate insulator 291 is greater than the amount of N-dipole dopant within gate insulator 292. In some further embodiments, gate insulator 292 lacks any of the Vt-shifting N-dipole dopant present within gate insulator 291. In other embodiments, both gate insulators 291 and 292 have a non-zero amount of the Vt-shifting N-dipole dopant, for example where the threshold voltage of both the pull-down and pass-gate transistors 125, 130 have threshold voltages that are reduced relative to other NMOS transistors of an IC, which may either be within bit-cell 105, or external to bit-cell 105.

An N-dipole dopant that reduces transistor threshold voltage of an NMOS transistor will increase the magnitude of transistor threshold voltage of an PMOS transistor. Similarly a P-dipole dopant that reduces transistor threshold voltage of a PMOS transistor will increase the magnitude of transistor threshold voltage of an NMOS transistor. Accordingly, in alternative embodiments where the Vt-shifting dipole dopant is a P-dipole dopant, an amount of the Vt-shifting P-dipole dopant within gate insulator 292 is greater than the amount of P-dipole dopant within gate insulator 291. In some further embodiments, gate insulator 291 lacks any of the Vt-shifting P-dipole dopant present within gate insulator 292. In other embodiments, both gate insulators 291 and 292 have a non-zero amount of the Vt-shifting P-dipole dopant, for example where the threshold voltage of both the pull-down and pass-gate transistors 125, 130 have threshold voltages magnitudes that are increased (albeit by different amounts) relative to other NMOS transistors of an IC, which may either be within bit-cell 105, or external to bit-cell 105.

In the exemplary 6-T SRAM layout 200, pull-down transistor 125 and pass-gate transistor 130 include separate regions of a nanoribbon 260 that is continuous over a length spanning one side of a bit-cell 105. Over this length, nanoribbon 260 has substantially the same transverse width W₁ to illustrate advantageous embodiments where area of bit-cell 105 (i.e., cell height) and/or layout complexity is minimized. However, the dipole threshold voltage tuning embodiments described herein may be readily applied to SRAM bit-cell layouts other than 6-T SRAM layout 200. For example, in some other bit-cell layouts, ribbon width may be modulated between pull-down transistor 125 and pass-gate transistor 130 in conjunction with the dipole dopant-based threshold voltage modulation described in detail below. However, in contrast to nanoribbon width modulation, which may impact the cell height of bit-cell 105, the illustrated embodiment represents an advantageously volumeless implementation.

As further illustrated in FIG. 2, pull-down transistor 125 and pass-gate transistor 130 include impurity doped semiconductor 275 of a first conductivity type (e.g., n-type), which extends an epitaxial width W_{E} beyond a sidewall of nanoribbons 260. In the exemplary embodiment, epitaxial width W_{E} is substantially the same for both pull-down transistor 125 and pass-gate transistor 130. A first semiconductor terminal (e.g., source) of pull-down transistor 125 comprising impurity doped semiconductor 275 is coupled to Vss through a contact metallization 280. A first semiconductor terminal (e.g., source) of pass-gate transistor 130 comprising impurity doped semiconductor 275 is coupled to a bitline BL through contact metallization 280.

A gate electrode 285 of pull-down transistor 125 is coupled to load/pull-up transistors 120. The gate electrode 285 of pass-gate transistor 130 is coupled to a wordline WL. A second semiconductor terminal (e.g., drain) of pull-down transistor 125 is in direct contact with a second semiconductor terminal (e.g., drain) of pass-gate transistor 130, each of which comprises impurity doped semiconductor 275 that is further coupled through contact metallization 280 to pull-up transistors 120.

Bit-cell 105 includes a second pull-down transistor 125 that comprises a portion of another stack of nanoribbons 260 and another instance of gate insulator 291. Another pass-gate transistor 130 couples an output of the inverters to a bitline bar BLB. This second instance of pass-gate transistor 130 comprises another portion of the stack of nanoribbons 260, which is coupled to another wordline WL through another instance of gate insulator 292. In some examples where pass-gate transistors 130 and pull-down transistors 125 are both n-type/n-channel devices, pull-up transistors 120 are p-type/p-channel transistors comprising impurity-doped semiconductor material 265 of a second, complementary conductivity type (e.g., p-type). Transistors 120 and 130 form two cross-coupled inverters where the output of one inverter is the input to the other inverter.

Pull-up transistors 120 comprise nanoribbons 260, also of a ribbon width Wi. Pull-up transistor ribbon width may however also vary with implementation. For example, pull-up transistor ribbon width may be greater or smaller than either pull-down transistor ribbon width or pass-gate transistor ribbon width. Pull-up transistors 120 comprise a gate insulator 290, which either includes a Vt-shifting dipole dopant, or not. If gate insulator 290 does include a Vt-shifting dipole dopant, it may include an amount that is either more than or less than that in either gate insulator 291 or 292 and that Vt-shifting dipole dopant may be either of the same type (e.g., N-dipole), or not (e.g., P-dipole). In some embodiments where gate insulator 291 comprises more N-dipole than gate insulator 292, and the drive strength of pull-up transistors 120 is less than that of pull-down transistors 125, gate insulator 290 has more of the Vt-shifting N-dipole dopant than gate insulator 292 and may have substantially the same Vt-shifting N-dipole dopant as gate insulator 291. In other embodiments where gate insulator 291 comprises more N-dipole than gate insulator 292, gate insulator 290 has substantially the same amount of Vt-shifting N-dipole dopant as gate insulator 292 so that the drive strength of pull-up transistors 120 is less than that of pass-gate transistors 130.

In still other embodiments where gate insulator 291 comprises less P-dipole dopant than gate insulator 292, gate insulator 290 has more Vt-shifting P-dipole dopant than gate insulator 291, for example so that the drive strength of pull-up transistors 120 may be greater than that of pass-gate transistors 130 and/or pull-down transistor 125.

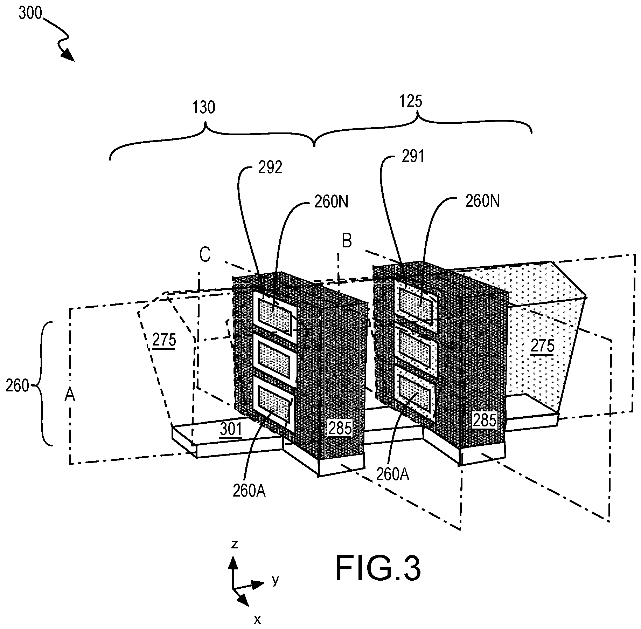

FIG. 3 is an isometric sectional view of an SRAM structure portion 300 further illustrating a gate-all-around stacked nanoribbon structure of pull-down and pass-gate transistors 125, 130, in accordance with some nanoribbon embodiments. The features illustrated in FIG. 3 may be present in any of the embodiments illustrated in FIG. 2, for example. Likewise, the features illustrated in FIG. 2 may be present in any of the embodiments illustrated in FIG. 3.

As shown in FIG. 3, transistors 125 and 130 each have a stacked, gate-all-around transistor architecture. Nanoribbons 260 include an uppermost nanoribbon 260N stacked in vertical alignment with a lowest nanoribbon 260A. The exemplary ribbon-or-wire (RoW) transistor stack structure is illustrated as including three nanoribbons, but such a transistor stack structure may include any integer number of channel regions (e.g., 2, 3, 4, 5...10...20, etc.) as embodiments herein are not limited in this respect.

Within pull-down transistor 125, a channel region of nanoribbons 260A-260N is surrounded by a gate stack that includes gate insulator 291. Gate insulator 291 is, in-turn, further surrounded by a gate electrode 285. Impurity-doped semiconductor 275 is at terminal ends of nanoribbons 260A-260N, on opposite sides of the gate stack. Pass-gate transistor 130 includes the same number of nanoribbons 260A-260N surrounded by a gate stack that includes gate insulator 292. Gate insulator 292 is further surrounded by a gate electrode 285. In accordance with the illustrated embodiment, all nanoribbons 260A-260N are coupled together in electrical parallel. The cumulative cross-sectional channel area is therefore a function of ribbon thickness (e.g., z-dimension) and ribbon width (e.g., x-dimension), which are both substantially the same in the illustrated embodiment.

In some embodiments, nanoribbons 260 are crystalline semiconductor. Although the crystalline semiconductor includes polycrystalline thin film material, the crystalline semiconductor may be advantageously substantially monocrystalline. In some such embodiments, the crystallinity of nanoribbons 260 is cubic with the top surfaces having crystallographic orientation of (100), (111), or (110), for example. Other crystallographic orientations are also possible. In some embodiments, nanoribbons 260 are a substantially monocrystalline group IV semiconductor material, such as, but not limited to substantially pure silicon (e.g., having only trace impurities), silicon alloys (e.g., SiGe), germanium alloys (GeSn), or substantially pure germanium (e.g., having only trace impurities).

Nanoribbons 260 may also have any of these same exemplary compositions in alternative polycrystalline or amorphous embodiments, for example where the stack of nanoribbons 260A-260N has been fabricated from a stack of thin film semiconductor material layers. Polycrystalline or amorphous embodiments of nanoribbons 260 may also include semiconducting metal oxides, such as IGZO. Although nanoribbons 260 are illustrated as having a substantially homogenous composition, they may alternatively comprise one or more semiconductor heterojunctions that, for example further include a first semiconductor material adjacent to a second semiconductor material.

Sub-channel material 301 is under the stack of nanoribbons 260. Sub-channel material 301 may have any composition and/or microstructure. For example, in some embodiments where nanoribbons 260 are of a Group IV material (e.g., silicon), sub-channel material 301 is also a Group IV material (e.g., silicon). In some further embodiments where nanoribbons 260 are substantially monocrystalline, sub-channel material 301 is also substantially monocrystalline, and has the same crystallinity and/or crystal orientation as that of nanoribbons 260. In alternative embodiments, sub-channel material 301 is a buried insulator layer (e.g., SiO₂), for example of a semiconductor-on-insulator (SOI) substrate.

Impurity doped semiconductor 275 is electrically and physically coupled to opposite sides of channel regions of nanoribbons 260A-260N. In this example, impurity doped semiconductor 275 comprises faceted epitaxial material that has been grown, for example laterally from an end portion of channel regions embedded within gate electrode 285, and/or from cantilevered source/drain ends of nanoribbons 260A-260N, and/or from sub-channel material 301. Impurity doped semiconductor 275 need not be epitaxial material, in which case the facets shown in FIG. 3 may not be present. Impurity doped semiconductor 275 also need not merge into a unitary body, in which case cantilevered source/drain nanowire ends may be individually in contact with contact metallization 280.

Impurity-doped semiconductor 275 may comprise one or more electrically active impurities. In some embodiments, for example, impurity-doped semiconductor 275 is a Group IV semiconductor material (e.g., Si, Ge, SiGe or GeSn alloy). For exemplary embodiments where pull-down and pass-gate transistors 125 and 130 are both NMOS, impurity doped semiconductor 275 comprises an n-type impurity such as phosphorus, arsenic, or antimony.

Gate electrode 285 co-axially clads the insulator-clad channel regions of nanoribbons 260 to provide gate-all-around control of channel conductivity. Gate electrode 285 may include any suitable workfunction metal, such as n-type workfunction metal, and is advantageously substantially the same for both pull-down transistor 125 and pass-gate transistor 130. Suitable n-type work function metals include, but are not limited to, hafnium, zirconium, titanium, tantalum, aluminum, and metal carbides that include these elements (e.g., titanium carbide, zirconium carbide, tantalum carbide, hafnium carbide and aluminum carbide).

Gate insulators 291 and 292 may have any composition, and may, for example, include a high-k material (e.g., with a bulk relative permittivity greater than 8). As described further below, a composition of gate insulator 291 is distinct from that of gate insulator 292 by an amount of Vt-shifting dipole dopant. In exemplary embodiments, the Vt-shifting dipole dopant includes a metal species distinct from any other within gate insulators 291, 292. The dipole dopant may be diffused within gate insulators 291 and/or 292, to be in close proximity to a channel region of nanoribbons 260. During manufacture, gate insulators 291 and 292 may be exposed to differing amounts, or types of the dipole dopant to provide a Vt contrast between pull-down transistor 125 (e.g., with a lower Vt) and gate-pass transistor 130 (e.g., with a higher Vt).

In exemplary embodiments, the metal species of a Vt-shifting dipole dopant is a rare earth and may be introduced into at least gate insulator 291, which alters the pull-down transistor threshold voltage from a reference threshold voltage the transistor would otherwise have in absence of the Vt-shifting dipole dopant. In exemplary embodiments where pull-down transistor 125 is an n-channel device, an N-type Vt shifting dipole is present within gate insulator 291. Accordingly, the threshold voltage of pull-down transistor 125 is a result of both a metal-semiconductor work function difference of gate electrode 285 and nanoribbons 260, and the amount of Vt shifting N-dipole dopant within gate insulator 291. For embodiments where gate insulator 292 lacks such a Vt shifting N-dipole material, the threshold voltage pass-gate transistor 130 is primarily the result of the metal-semiconductor work function difference of gate electrode 285 and nanoribbons 260.

In other embodiments where pull-down transistor 125 is an n-channel device, a P-type Vt shifting dipole is absent from gate insulator 291, but present within gate insulator 292. Hence, gate insulator 292 may be dipole doped with the same P-dipole dopant that may be similarly introduced into a PMOS pull-up transistor, for example as a means of achieving a desired Vₜ for the PMOS pull-up transistor while concurrently providing a threshold voltage contrast between NMOS pull-down transistor 125 and pass-gate transistor 130 described herein.

In FIG. 3, planes A, B C are demarked by dashed lines. Plane A is a "gate-cut" plane that passes through a transverse width of gate electrode 285 and through a longitudinal length of nanoribbons 260. Plane B is a "ribbon-cut" plane that passes through a transverse width of nanoribbons 260 and through a longitudinal length of gate electrode 285 of pull-down transistor 125. Plane C is a another "ribbon-cut" plane that passes through a transverse width of nanoribbons 260 and through a longitudinal length of gate electrode 285 of pass-gate transistor 130.

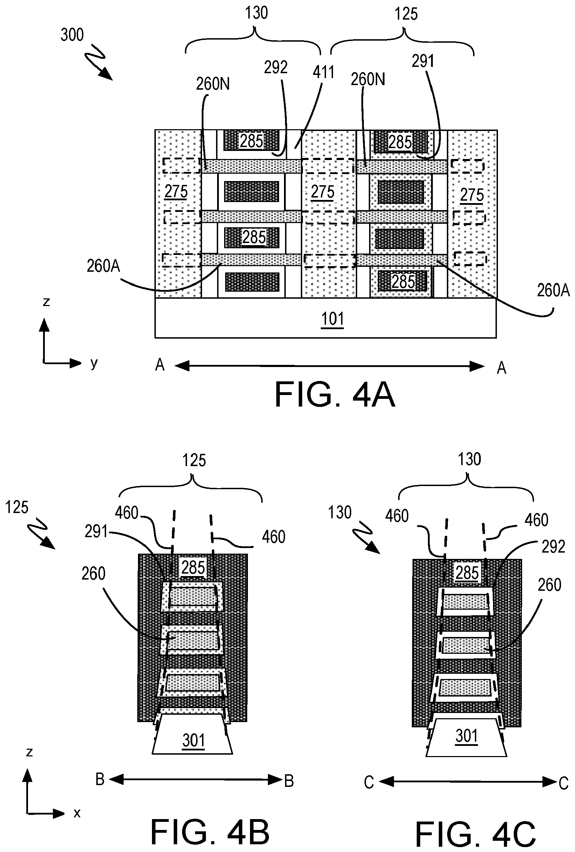

FIG. 4A illustrates a cross-sectional view of transistors 125, 130 along the A plane introduced in FIG. 3, in accordance with some embodiments. FIG. 4B illustrates a cross-sectional view of pull-down transistor 125 along the B plane introduced in FIG. 3, in accordance with some embodiments. FIG 4C illustrates a cross-sectional view of pass-gate transistor 130 along the C plane introduced in FIG. 3, in accordance with some embodiments.

Referring first to FIG. 4A, nanoribbons 260 are bodies of semiconductor material that extend through channel regions of both transistors 125 and 130. Along the pull-down and pass-gate channel lengths, gate electrode 285 clads each of gate insulator 291 and gate insulator 292. Gate insulators 291 and 292 further clad nanoribbons 260. In this example, nanoribbons 260 also extend through a dielectric spacer 411. In some embodiments, nanoribbons 260 may also extend through impurity-doped semiconductor 275 as denoted by dashed lines in FIG. 4A. In alternative embodiments, nanoribbons 260 may be completely absent beyond dielectric spacer 411 with impurity-doped semiconductor 275 then being a unitary body intervening between two separate stacks of nanoribbons 260.

As further shown in FIG. 4B and FIG. 4C, nanoribbons 260 may have been patterned from a fin of a substrate material layer, for example having the dashed nanoribbon sidewalls 460. The slightly positive slope of sidewalls 460 results in each of nanoribbons 260A-260N having a trapezoidal slab profile representative of structural asymmetry associated with front-side transistor fabrication. Such asymmetry may be a result of nanoribbon sidewall 460 evolving during subtractive patterning of a fin into a stack of semiconductor materials, for example. Although nanoribbons 260 are illustrated as having a transverse (x) width greater than their vertical thickness, nanoribbons 260 may instead have a vertical (z) thickness greater than, or substantially equal to, their transverse width.

Although gate insulator stack thicknesses may vary with technology generation, in some exemplary embodiments where an SRAM bit-cell is operable at voltages under 1V (e.g., 0.6 V-0.8V), gate insulator 291 and 292 have a thickness less than 3 nm (e.g., 1.5-3.0 nm). Gate insulators 291 and 292 may include any number of material layers. In some exemplary embodiments, both of gate insulators 291 and 292 include a thermal (chemical) oxide in addition to a high-k material. The chemical oxide may be present only on interfaces with nanoribbons 260. In some embodiments where nanoribbons are substantially pure silicon, the chemical oxide layer comprises predominantly silicon and oxygen. The chemical oxide may have any thickness, but in some examples is at least 1.0 nm. Gate insulators 291 and 292 may therefore be considered a stack of both a chemical oxide and a high-k material.

Both gate insulators 291 and 292 may have a high-k material of substantially the same chemical composition. The high-k material composition(s) may be any known to be suitable for a transistor gate insulator and that has a bulk relative permittivity greater than 8. One exemplary high-k material has a composition of M1Oₓ where M1 is a transition or rare earth metal. Examples include a metal oxide comprising predominantly hafnium (e.g., HfOₓ), a metal oxide comprising predominantly aluminum (e.g., AlOₓ), a metal oxide comprising predominantly magnesium (e.g., MgO), a metal oxide comprising predominantly lanthanum (e.g., LaOₓ), or a metal oxide comprising predominantly zirconium (e.g., ZrOₓ). In other examples, the high-k material is an alloyed metal oxide comprising primarily two or more metals (e.g., HfAlOₓ, HfZrOₓ). In some further embodiments, the high-k material further includes silicon. For example, metal silicates, such as, but not limited to HfSiOₓ, or ZrSiOₓ, may also be suitable a high-k material for insulators 291 and 292.

While both gate insulators 291 and 292 may include the same chemical oxide and same high-k material, the two gate insulators differ compositionally at least in the amount of a Vt shifting dipole present. In exemplary embodiments, the Vt shifting dipole comprises a metal M2 and may advantageously be an oxide of a rare earth metal that is distinct from any other metal present gate insulators 291 and 292. The chemical compositions of gate insulator 291 and 292 are therefore different by at least the amount (concentration) of this dipole dopant metal species.

As noted above, in some embodiments dipole dopant metal M2 is substantially absent from gate insulator 292. However, in other embodiments dipole dopant metal M2 is present in gate insulator 292, but at lower concentration than within gate insulator 291. In still other embodiments where a dipole dopant metal is associated with a dipole of complementary type, M2 may be present in gate insulator 292, but absent from, or present at a lower concentration in, gate insulator 291. Any of these embodiments may accordingly provide the Vt threshold contrast between pass-gate and pull-down transistors described herein. Whether associated with an N-dipole or P-dipole, the contrasting amounts of dipole dopant metal M2 may be determined through chemical analysis of the gate insulators 291 and 292, for example by STEM-EELS (electron energy-loss spectroscopy)/EDS (energy dispersive x-ray spectroscopy), or 2.5D TOF-SIMS (time-of-flight secondary ion mass spec spectroscopy).

Within at least insulator 291, an exemplary dipole dopant metal M2 may be present within a chemical oxide layer, and therefore in very close proximity (e.g., within 1.0 nm) to nanoribbons 260. For such embodiments, gate insulators 291 and 292 have chemical oxides that differ by the amount of metal M2 present. The dipole dopant metal M2 may be substantially absent from the high-k material or may be present within high-k material in addition to (or instead of) being within chemical oxide. In some embodiments of gate insulator 291 where dipole dopant metal M2 is present within high-k material, the concentration of the dipole dopant metal M2 within the high-k material is less than the concentration of high-k metal M1 within the high-k material. Hence, the high-k material may still be considered primarily M1Oₓ with some dipole metal M2 present as a dipole dopant. In some examples where the metal species M2 is associated with an N-dipole, the concentration of the metal species M2 to the concentration of the metal species M1 within gate insulator 291 is between 0.1 and 0.2. As a further example, a ratio of the concentration of the metal species M2 to the concentration of the metal species M1 within gate insulator 292 is between 0 and 0.1.

Dipole dopant metal M2 may be present within insulator 291 as non-ionic oxide (e.g., M2Oₓ) or as an ionic oxide. Exemplary ionic oxides may further comprise silicon (e.g., as a silicate) when dipole dopant metal M2 is within the chemical oxide, or may further comprise metal M1 (e.g., as a hafnate) when M2 is within the high-k material (e.g., HfOₓ). The dipole metal M2 may be any metal that forms a stable dipole compound, including metals known to be suitable as high-k dielectric materials as well as metals that form compounds having somewhat lower dielectric constants. For example, any of the metals listed above as suitable choices for the high-k material may also be suitable as dipole dopant metal M2. Dipole dopant metal M2 may be selected based on dipole properties of compounds it forms within the chemical oxide and/or high-k material to achieve a particular transistor threshold voltage modulation for a given transistor conductivity type.

In some embodiments where pull-down transistor 125 and pass-gate transistor are N-channel devices, an N-dipole dopant metal M2 preferentially incorporated into gate insulator 291 is at least one of Mg (e.g., forming a dipole dopant s MgOₓ, MgSiOₓ, or MgHfOₓ, etc.), Ca (e.g., forming a dipole dopant CaOₓ, CaSiOₓ, or CaHfOₓ, etc.), Sr (e.g., forming a dipole dopant SrOₓ, SrSiOₓ, or SrHfOₓ, etc.), Ba (e.g., forming a dipole dopant BaOₓ, or BaSiOₓ, BaHfOₓ, etc.), La (e.g., forming a dipole dopant LaOₓ, LaSiOₓ, or LaHfOₓ, etc.), Sc (e.g., forming a dipole dopant ScOₓ, ScSiOₓ, or ScHfOₓ, etc.), or Y (e.g., forming a dipole dopant YOx, or YSiOx, YHfOx, etc.), or Gd (e.g., forming a dipole dopant GdOx, or GdSiOx, GdHfOₓ, etc.), or Er (e.g., forming a dipole dopant ErOₓ, or ErSiOₓ, ErHfOₓ, etc.), or Yb (e.g., forming a dipole dopant YbOₓ, or YbSiOₓ, YbHfOₓ, etc.), or Lu (e.g., forming a dipole dopant LuOx, or Lu,SiOx, LuHfOx, etc.).

In alternative embodiments where pull-down transistor 125 and pass-gate transistor are N-channel devices, a P-dipole dopant metal M2 preferentially incorporated into gate insulator 291 is at least one of Al (e.g., forming a dipole as AlOₓ, AlSiOₓ, or AlHfOₓ, etc.), Ga (e.g., forming a dipole species GaOₓ, GaSiOₓ, or GaHfOₓ, etc.), Mo (e.g., forming a dipole species MoOₓ, MoSiOₓ, or MoHfOₓ, etc.), or Co (e.g., forming a dipole species CoOx, CoSiOx, or CoHfOₓ, etc.), or Ni (e.g., forming a dipole species NiOx, NiSiOx, or NiHfOx, etc.), or Nb (e.g., forming a dipole species NbOx, NbSiOx, or NbHfOₓ, etc.).

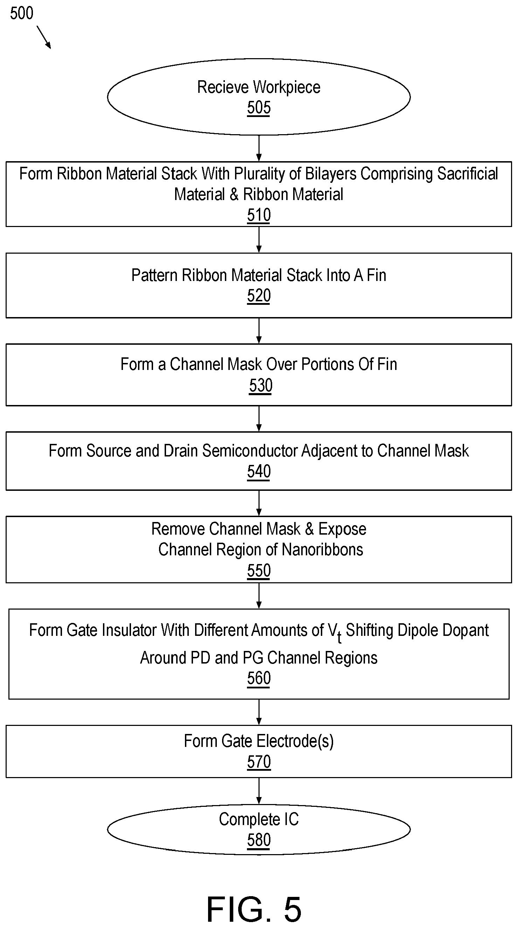

Regardless of the polarity of the specific dipole dopant, dipole dopant-based Vt contrast provided between pull-down and pass-gate transistors may be implemented by introducing the Vt shifting dipole dopant metal M2 from a solid state dipole dopant source material deposited during the practice of any IC fabrication process suitable for fabricating stacked GAA transistor structures. FIG. 5 is a flow diagram of methods 500 for fabricating an SRAM bit-cell with gate insulators of contrasting dipole dopant content, in accordance with some embodiments.

Methods begin at input 505 where a workpiece is received. In some embodiments, the workpiece received at input 505 is a wafer suitable for IC die fabrication. The workpiece may, for example, further include part of a workpiece substrate (e.g., a large format semiconductor wafer) that is to become an IC chip. At block 510, a nanoribbon material stack is formed. The nanoribbon material stack may advantageously include a plurality of bilayers comprising a sacrificial material and ribbon material. In some embodiments, the sacrificial material layers include more germanium than the ribbon material. For example, where the ribbon material is predominantly silicon, the sacrificial layers are Si₁₋ₓGeₓ.

At block 520, the ribbon material stack is patterned into one or more fins including a portion where a pull-down transistor will be fabricated and a portion where a pass-gate transistor will be fabricated. Any patterning process, such as an extreme ultraviolet (EUV) lithography process, may be practiced at block 520 to define a fin mask. Any subtractive etch may be practiced at block 520 to delineate features (e.g., fins) into the nanoribbon material stack. In some embodiments, a plasma etch process may be utilized to define such features.

At block 530, channel portions of the features patterned at block 520 are protected with a channel mask. In some embodiments, the channel mask formed over exposed portions of the fin includes a sacrificial gate stack. At block 540, source and drain regions are formed adjacent to the channel mask, for example by epitaxially growing impurity-doped semiconductor with a low pressure CVD (LPCVD) process. In exemplary embodiments where pull-down and pass-gate transistors a N-channel devices, source and drain regions grown at block 540 may include predominantly silicon, and one or more n-dopants such as phosphorus, arsenic, or antimony.

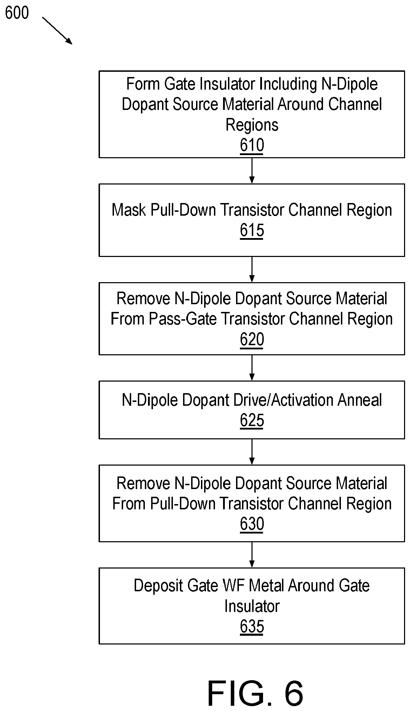

At block 550, the channel mask and sacrificial material is removed to expose channel regions of the nanoribbons. At block 560 gate insulators with different amounts of Vt-shifting dipole dopant is formed around pull-down and pass-gate transistors. Methods 600 (FIG. 6) then continue at block 570 where a gate electrode is formed around the gate insulators of each of pull-down and pass-gate transistors. Methods 500 then end at output 580 where any known fabrication techniques may be practiced to complete an IC including the SRAM bit-cell. For example, any number of levels of interconnect metallization may be fabricated according to any back-end-of-line (BEOL) processes known to be suitable for integrated circuits (ICs).

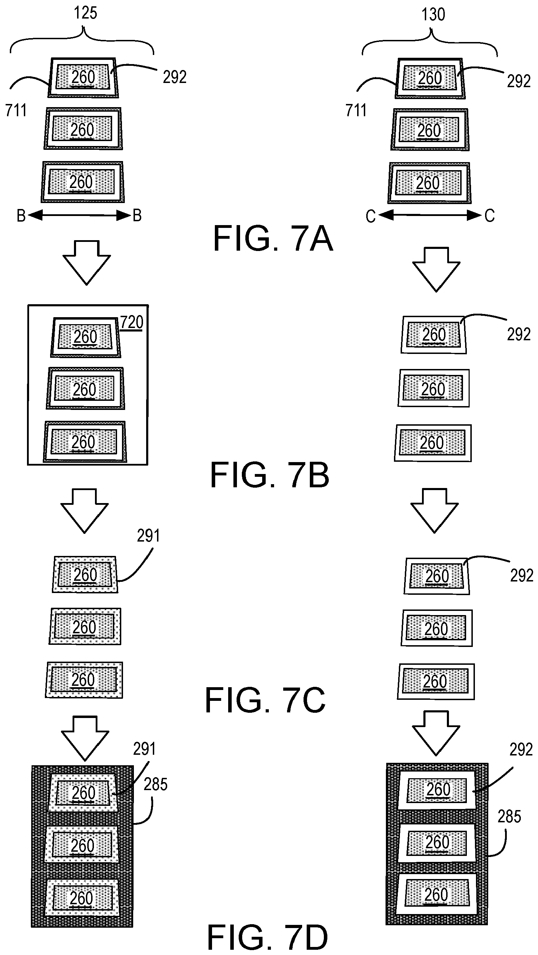

FIG. 6 is a flow diagram illustrating methods 600 for dipole dopant Vt modulation, in accordance with some embodiments where the pass-gate and pull-down transistors are both NMOS and the dipole dopant is an N-dipole dopant. Methods 600 may be practiced, for example, at block 560 of methods 500. FIG. 7A-7D illustrate cross-sectional views of an NMOS pull-down transistor structure and an NMOS pass-gate transistor structure evolving as methods 600 are practiced, in accordance with some embodiments. The cross-sectional views in 7A-7D are along the same B and C planes introduced in FIG. 4B and 4C.

Referring first to FIG. 6, methods 600 begin at block 610 where a gate insulator including an N-dipole dopant source material is formed around channel regions of one or more nanoribbons. Block 610 may include any of thermal oxidation, plasma-assisted oxidation, UV-assisted oxidation, chemical vapor deposition, or thermal atomic layer deposition (ALD) processes. Each of these techniques may form a chemical oxide selectively upon surfaces of the channel regions of nanoribbons. As one example, a thermal ALD process may include a co-reactant phase where an oxygen precursor, such as ozone is introduced. The thermal ALD cycle may also include a deposition phase during which a silicon precursor (e.g., an amino silane) is introduced. One or more such cycles may be performed to form one or more layers of chemical oxide (e.g., SiO₂) upon channel regions of the nanoribbons. Depending on the deposition technique, various trace levels of impurities, such as hydrogen and/or carbon, may be unintentionally introduced into the chemical oxide, but the material may be otherwise substantially pure (e.g., SiO₂).

Any of the high-k dielectric materials described above may be further formed at block 610, for example with a CVD or ALD process. An ALD half-reaction precursor may, for example, include a first metal. A co-reactant half-reaction precursor may, for example, include oxygen. Any number of ALD cycles may be performed at block 610 to reach a desired high-k dielectric material thickness (e.g., 1.0-2.0 nm).

An N-dipole dopant source material is further formed at block 610. The N-dipole dopant source material may be deposited by another CVD or cyclic ALD process. In an ALD process, a deposition half-reaction precursor may comprise a second metal (i.e., the dipole metal M2), while the co-reactant half-reaction precursor includes oxygen. Any number of such ALD cycles may be performed at block 610 to reach a desired thickness of dipole dopant source material. In exemplary embodiments, one to five such cycles are performed, for example to deposit 0.5-2.0 nm of dipole dopant source material.

In the example illustrated in FIG. 7A, both pull-down transistor 125 and pass-gate transistor 130 include an N-dipole dopant source material 711 on gate insulator 292. As described above, gate insulator 292 may include both chemical oxide and high-k dielectric material. N-dipole dopant source material 711 may vary, but may be any of those listed above, for example. In some exemplary embodiments, N-dipole dopant source material 711 comprises La (e.g., LaOₓ).

Returning to FIG. 6, methods 600 continue at block 615 where the pull-down transistor channel region is masked with any suitable mask material to protect the dipole dopant source material from an etchant (e.g., wet chemical) that removes the N-dipole dopant source material from the pass-gate transistor at block 620. FIG. 7B further illustrates an embodiment where a protective mask material 720, such as diamond-like carbon (DLC), protects pull-down transistor 125. As further shown, in an absence of mask material 720, N-dipole dopant source material 711 is removed from pass-gate transistor 130, exposing gate insulator 292.

Returning to FIG. 6, methods 600 continue at block 625 where N-dipole dopants are thermally driven from the dipole dopant source material toward the channel region of pull-down transistor 125 and/or pass-gate transistor 130. The mask material may be removed before or after the drive/activation. In exemplary embodiments, diffusion of the Vt shifting N-dipole dopant is driven by elevated temperature processing. One or more thermal processes may be performed at block 625 to diffuse the N-dipole toward the channel regions until it comes to rest, for example, within a chemical oxide layer between the high-k dielectric material layer and the channel material. Block 625 may, for example, include a heat cycle during which the transistor stack structures reach a temperature of over 500°C (e.g., 700°C, 750°C, 800°C, or 850°C) for a predetermined time in the presence of any suitable ambient, such as, but not limited to, nitrogen (N₂), or forming gas (N₂:H₂).

Following the thermal drive/activation, methods 600 continue at block 630 where the N-dipole dopant source material is removed from the pull-down transistor channel region (and anywhere else it was retained). Any suitable etch process (e.g., wet chemical) may be practiced at block 630. In some embodiments, the etch process performed at block 620 is repeated at block 630. In the example further illustrated in FIG. 7C, gate insulator 291 is formed where gate insulator 292 has been doped with the N-dipole dopant. In the absence of any dipole dopant source material around pass-gate transistor 130, gate insulator 292 remains substantially unchanged.

Returning to FIG. 6, methods 600 complete at block 635 where a gate electrode including a material (e.g., metal) with a suitable workfunction, such as one of those described above, is deposited around each of gate insulators 291, 292. Any deposition process suitable for the material may be practiced at block 635. In some embodiments, a gate electrode workfunction metal is deposited with an ALD process. In the example shown in FIG. 7D, the gate stacks of both pull-down transistor 125 and pass-gate transistor 130 are substantially complete with gate electrode 285 surrounding each of gate insulator 291 and gate insulator 292.

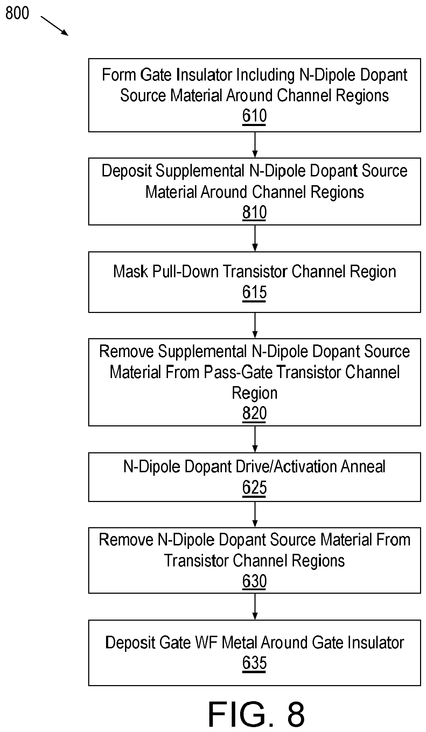

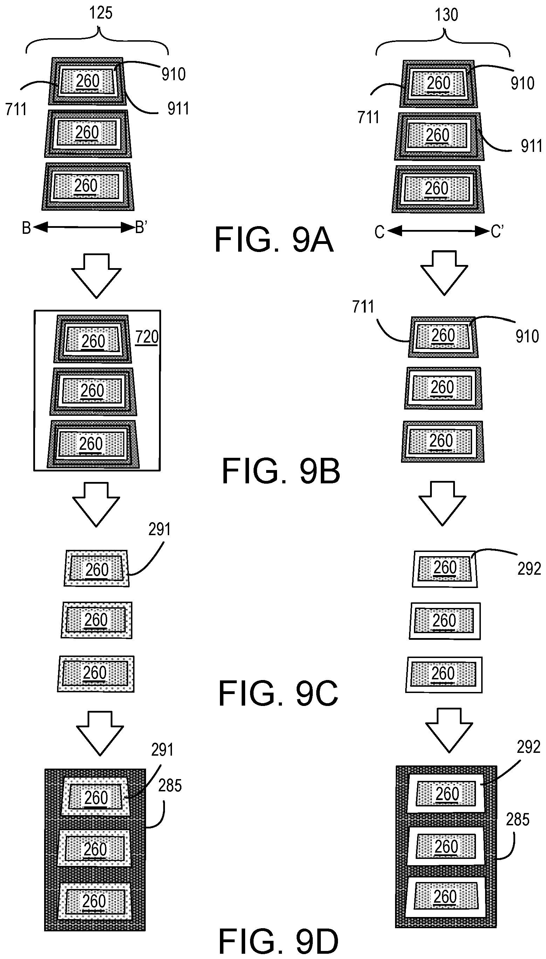

FIG. 8 is a flow diagram illustrating methods 800 for dipole dopant Vt modulation, in accordance with some alternative embodiments where both pull-down and pass-gate transistors receive some N-dipole dopant-based threshold voltage tuning. FIG. 9A- 9D illustrate cross-sectional views of a pull-down transistor structure and a pass-gate transistor structure evolving as methods 800 are practiced, in accordance with some embodiments. The cross-sectional views in 9A-9D are along the same B and C planes illustrated in FIG. 7A-7D.

Referring first to FIG. 8, methods 800 again begin with block 610 where a gate insulator including N-dipole dopant source material is formed around at least the NMOS pull-down and pass-gate transistors of an SRAM bit-cell. Other transistors in the SRAM bit-cell (e.g., pull-up transistors), or external to the bit-cell (e.g., logic core) may also have the same gate insulator at this point in the manufacturing process.

Methods 800 continue at block 810 where supplemental N-dipole dopant source material is formed around channel regions around at least the pull-down and pass-gate transistors of an SRAM bit-cell. Any of the dipole dopant source materials described above may be deposited as a supplement at block 810. The supplemental N-dipole dopant source material may be another layer of the same source material deposited at block 610, for example increasing the source material layer thickness. Alternatively, a second N-dipole dopant source material of a different composition that that deposited at block 610 may be deposited at block 810. FIG. 9A illustrates an example where both pull-down transistor 125 and pass-gate transistor 130 initially have substantially the same gate insulator material stack including an insulator material 910, N-dipole dopant source material 711 on insulator material 910, and an N-dipole dopant source material 911 on N-dipole dopant source material 711. In some exemplary embodiments where N-dipole dopant source material 711 is a La source material (e.g., LaOₓ), N-dipole dopant source material 911 is the same La source material (LaOₓ).

Returning to FIG. 8, methods 800 continue at block 615 where the pull-down transistor channel region is again masked, for example substantially as described above. At block 820 the supplemental dipole dopant source material is removed from the unmasked pass-gate channel region, for example with any wet-chemical etch suitable for the supplemental dipole dopant source material. In some embodiments, an etch is performed at block 615 for a predetermined time to remove only a thickness of dipole dopant source material associated with the supplemental dipole dopant source material. In the example illustrated in FIG. 9B, N-dipole dopant source material 911 has been removed, leaving N-dipole dopant source material 711 over the channel regions of pass-gate transistor 130.

Returning to FIG. 8, methods 800 continue at block 625 where the N-dipole dopant is thermally diffused and/or activated, for example substantially as described above. With a greater amount of N-dipole dopant source material being present around channel regions of the pull-down transistor, more of the N-dipole dopant diffuses toward the channel regions of the pull-down transistor than for the pass-transistor. Following the dipole dopant drive/activation, the source material(s) may be removed at block 630, for example substantially as described above. In the example illustrated in FIG. 9C, the thermal process has doped insulator material 910 of pass-gate transistor 130 with a lesser amount of N-dipole dopant to form gate insulator 292, and doped insulator material 910 of pull-down transistor 125 with a greater amount of N-dipole dopant to form gate insulator 291.

Methods 800 (FIG. 8) are then completed at block 635 where the gate electrode is formed, for example substantially as described above, to arrive at the gate stack substantially as further illustrated in FIG. 9D.

Notably, methods 600 and 800 may be modified as described above in the context of FIG. 2-5 to implement dipole-based Vt contrast in pull-down and pass-gate transistors with P-dipole dopants. For such embodiments, the treatments of the pull-down and pass-gate transistors described in the context of methods 600 and 800 are reversed to account for the complementary effect of on threshold voltage of the P-dipole dopant.

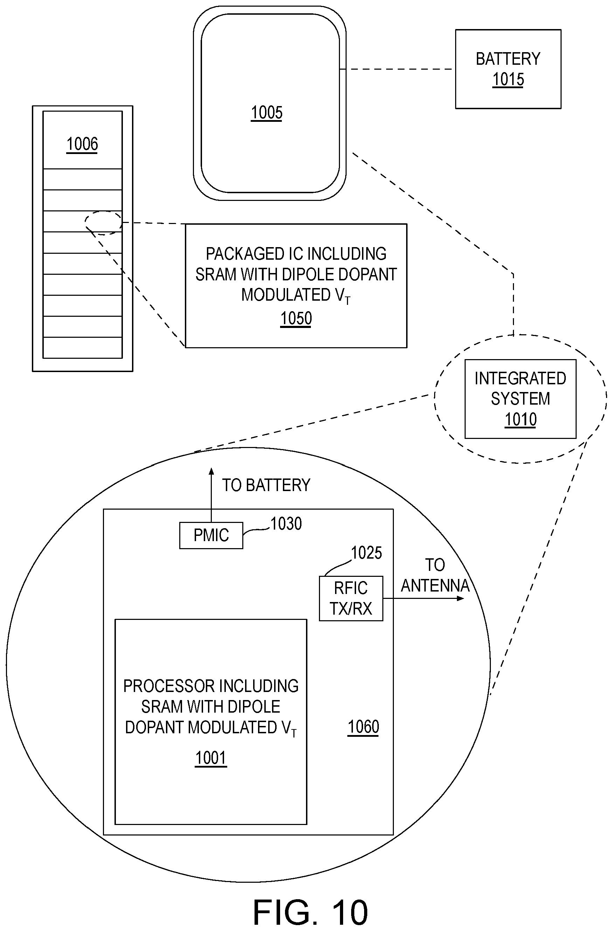

SRAM bit-cells with pull-down and pass-gate transistors having a dipole dopant-based threshold voltage contrast may be integrated into a wide variety of ICs and computing systems that include such ICs. FIG. 10 illustrates a mobile computing platform 1005 and a data server computing platform 1006 employing a packaged IC including an SRAM with dipole dopant-based modulated threshold voltages, for example substantially as described elsewhere herein. The server platform 1006 may be any commercial server, for example including any number of high-performance computing platforms disposed within a rack and networked together for electronic data processing, which in the exemplary embodiment includes a packaged IC 1050 including an SRAM with including an SRAM with dipole dopant-based modulated threshold voltages, for example substantially as described elsewhere herein.

The mobile computing platform 1005 may be any portable device configured for each of electronic data display, electronic data processing, wireless electronic data transmission, or the like. For example, the mobile computing platform 1005 may be any of a tablet, a smart phone, laptop computer, etc., and may include a display screen (e.g., a capacitive, inductive, resistive, or optical touchscreen), a chip-level or package-level integrated system 1010, and a battery 1015. At least one IC of chip-level or package-level integrated system 1010 includes packaged IC with an SRAM that has dipole dopant-based modulated threshold voltages, for example substantially as described elsewhere herein.

In the example shown in the expanded view, integrated system 1010 includes a microprocessor 1001 that includes an SRAM with dipole dopant-based modulated threshold voltages, for example substantially as described elsewhere herein. Microprocessor 1001 may be further coupled to a host substrate 1060. One or more of a power management integrated circuit (PMIC) 1030 or an RF (wireless) integrated circuit (RFIC) 1025 including a wideband RF (wireless) transmitter and/or receiver (TX/RX) may be further coupled to host substrate 1060.

Functionally, PMIC 1030 may perform battery power regulation, DC-to-DC conversion, etc., and so has an input coupled to battery 1015 and with an output providing a current supply to other functional modules (e.g., microprocessor 1001). As further illustrated, in the exemplary embodiment, RFIC 1025 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 4G, 5G, and beyond.

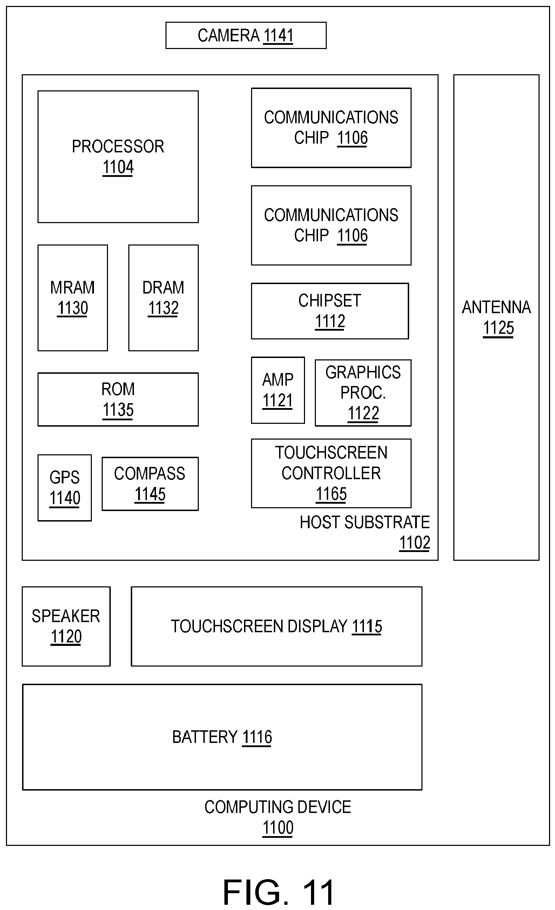

FIG. 11 is a functional block diagram of an electronic computing device 1100, in accordance with an embodiment of the present invention. Computing device 1100 may be found inside platform 1005 or server platform 1006, for example. Device 1100 further includes a host substrate 1102 hosting a number of components, such as, but not limited to, a processor 1104 (e.g., an applications processor with an arithmetic logic unit). Processor 1104 may be physically and/or electrically coupled to host substrate 1102. In some examples, processor 1104 includes an SRAM with dipole dopant-based modulated threshold voltages, for example substantially as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1106 may also be physically and/or electrically coupled to the host substrate 1102. In further implementations, communication chips 1106 may be part of processor 1104. Depending on its applications, computing device 1100 may include other components that may or may not be physically and electrically coupled to host substrate 1102. These other components include, but are not limited to, volatile memory (e.g., DRAM 1132), non-volatile memory (e.g., ROM 1135), flash memory (e.g., NAND or NOR), magnetic memory (MRAM 1130), a graphics processor 1122, a digital signal processor, a crypto processor, a chipset 1112, an antenna 1125, touchscreen display 1115, touchscreen controller 1165, battery 1116, audio codec, video codec, power amplifier 1121, global positioning system (GPS) device 1140, compass 1145, accelerometer, gyroscope, speaker 1120, camera 1141, and mass storage device (such as hard disk drive, solid-state drive (SSD), compact disk (CD), digital versatile disk (DVD), and so forth), or the like. In some exemplary embodiments, at least one of the functional blocks noted above include SRAM with dipole dopant-based modulated threshold voltages, for example substantially as described elsewhere herein.

Communication chips 1106 may enable wireless communications for the transfer of data to and from the computing device 1100. The term "wireless" and its derivatives may be used to describe circuits, devices, systems, methods, techniques, communications channels, etc., that may communicate data using modulated electromagnetic radiation through a non-solid medium. The term does not imply that the associated devices do not contain any wires, although in some embodiments they might not. Communication chips 1106 may implement any of many wireless standards or protocols, including but not limited to those described elsewhere herein. As discussed, computing device 1100 may include a plurality of communication chips 1106. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

It will be recognized that the invention is not limited to the exemplary embodiments described in detail but can be practiced with modification and alteration without departing from the scope of the appended claims. For example, the above embodiments may include specific combinations of features as further provided below.

In first examples, a static random-access memory (SRAM) bit-cell structure comprises a first transistor comprising a first gate electrode around a channel region of a first stack of nanoribbons, and a first gate insulator between the first gate electrode and the channel region of the first stack of nanoribbons. The first gate insulator comprises a high-k gate material layer comprising oxygen and a first metal species. The bit-cell structure comprises a second transistor of a same conductivity type as the first transistor. The second transistor comprises a second gate electrode around a channel region of a second stack of nanoribbons, a second gate insulator between the second gate electrode and the channel region of the second stack of nanoribbons. The second gate insulator comprises the high-k material layer. An amount of a dipole dopant comprising a second metal species differs between the first or second gate insulators.

In second examples, for any of the first examples the first and second transistors are NMOS device structures, the dipole dopant is an N-dipole dopant, and the second gate insulator comprises more of the dipole dopant than the first gate insulator.

In third examples, for any of the first through second examples the first metal species is a first of Hf, Al, Zr, or Y,the second metal species is Mg, Ca, Sr, La, Sc, Ba, Gd, Er, Yb, Lu, Ga, Mo, Co, Ni, Nb, or a second of Hf, Al, Zr, or Y.

In fourth examples, for any of the first through second examples within the second gate insulator, a ratio of a concentration of the second metal species to a concentration of the first metal species is between 0.1 and 0.2. Within the second gate insulator, a ratio of a concentration of the second metal species to a concentration of the first metal species is between 0 and 0.1.

In fifth examples for any of the first through second examples the first gate insulator also comprises the dipole dopant but at a lower concentration than that of the second gate insulator.

In sixth examples, for any of the first through second examples the dipole dopant is absent from the first gate insulator.

In seventh examples, for any of the first examples the first and second transistors are NMOS device structures the dipole dopant is a P-dipole dopant, and the second gate insulator comprises less of the dipole dopant than the first gate insulator.

In eighth examples, for any of the first through seventh examples the first transistor is a pass-gate transistor, the second transistor is a pull-down transistor and the SRAM bit-cell structure further comprises a pair of pull-up transistors. Each of the pull-up transistors further comprises a third stack of nanoribbons, a third gate electrode around a channel region of the third stack of nanoribbons, and a third gate insulator between the third gate electrode and the channel region of the third stack of nanoribbons, wherein the third gate insulator comprises the high-k gate material layer and lacks the dipole dopant.

In ninth examples, for any of the first through eighth examples the first stack of nanoribbons and the second stack of nanoribbons have substantially the same composition, the first gate electrode and the second gate electrode have substantially the same composition, the first transistor has a first threshold voltage, and the second transistor has a second threshold voltage, different than the first threshold voltage.

In tenth examples for any of the ninth examples a magnitude of the first threshold voltage is higher than the magnitude of the second threshold voltage.

In eleventh examples, a device comprises a microprocessor comprising an arithmetic logic unit, a cache memory comprising an SRAM array, and a power supply coupled to power the microprocessor. The SRAM array comprises a plurality of bit-cells and each bit cell comprises a first NMOS transistor, comprising a first stack of nanoribbons, a first gate electrode around a channel region of the first stack of nanoribbons, and a first gate insulator between the first gate electrode and the channel region of the first stack of nanoribbons. The first gate insulator comprises a high-k gate material layer comprising oxygen and a first metal species. Each bit-cell comprises a second NMOS transistor comprising a second stack of nanoribbons, a second gate electrode around a channel region of the second stack of nanoribbons, and a second gate insulator between the second gate electrode and the channel region of the second stack of nanoribbons. The second gate insulator comprises the high-k material layer and an N-dipole dopant comprising a second metal species.

In twelfth examples, for any of the eleventh examples the device further comprises a battery coupled to the power supply.

In thirteenth examples, a method of fabricating a static random-access memory (SRAM) structure comprises forming a transistor material stack including a plurality of bilayers comprising sacrificial material and channel material, patterning the transistor material stack into a fin. The method comprises forming a first gate insulator comprising a first metal species and a first amount of second metal species around a pull-down transistor region of the channel material, and forming a second gate insulator comprising the first metal species and a second amount of the second metal species, different than the first amount, around a pass-gate transistor region of the channel material. The method comprises forming a gate electrode material around the first gate insulator, and forming the gate electrode material around the second gate insulator.

In fourteenth examples, for any of the thirteenth examples forming the first gate insulator and the second gate insulator comprises forming a gate insulator material including an N-dipole dopant source material comprising the second metal species around the pull-down and pass-gate transistor regions, removing more of the N-dipole dopant source material from the pass-gate transistor region than from the pull-down transistor region, and thermally annealing the structure.

In fifteenth examples, for any of the fourteenth examples the method comprises removing substantially all of the N-dipole dopant source material from the pull-down transistor region, and depositing the gate electrode material.

In sixteenth examples for any of the fourteenth examples removing more of the N-dipole dopant source material from the pass-gate transistor region than from the pull-down transistor region comprises masking the pull-down transistor region, and removing substantially all of the N-dipole dopant source material from the pass-gate transistor region.

In seventeenth examples, for any of the fourteenth examples forming a gate insulator material including the N-dipole dopant source material comprising the second metal species around the pull-down and pass-gate transistor regions further comprises depositing a first layer of the dipole N-dopant source material around both the pull-down and pass-gate transistor regions, and depositing a second layer of the N-dipole dopant source material around only the pull-down transistor region.

In eighteenth examples, for any of the seventeenth examples removing more of the N-dipole dopant source material from the pass-gate transistor region than from the pull-down transistor region further comprises masking the pull-down transistor region, and removing the second layer of the N-dipole dopant source material from the pass-gate transistor region without removing all of the first layer of the N-dipole dopant source material.

In nineteenth examples, for any of the thirteenth through eighteenth examples the first metal species is a first of Hf, Al, Zr, or Y, and wherein the second metal species is Mg, Ca, Sr, La, Sc, Ba, Gd, Er, Yb, Lu, Ga, Mo, Co, Ni, Nb, or a second of Hf, Al, Zr, or Y.

In twentieth examples, for any of the thirteenth through nineteenth examples the second amount of the second metal species is less than the first amount and the pass-gate transistor has a first threshold voltage, the pull-down transistor has a second threshold voltage, and a magnitude of the first threshold voltage is higher than the magnitude of the second threshold voltage.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

## Claims

1. A static random-access memory (SRAM) bit-cell structure, comprising:
a first transistor, comprising:
a first gate electrode around a channel region of a first stack of nanoribbons; and
a first gate insulator between the first gate electrode and the channel region of the first stack of nanoribbons, wherein the first gate insulator comprises a high-k gate material layer comprising oxygen and a first metal species; and
a second transistor of a same conductivity type as the first transistor, the second comprising:
a second gate electrode around a channel region of a second stack of nanoribbons; and
a second gate insulator between the second gate electrode and the channel region of the second stack of nanoribbons, wherein the second gate insulator comprises the high-k material layer, and wherein an amount of a dipole dopant comprising a second metal species differs between the first and second gate insulators.

2. The SRAM bit-cell structure of claim 1, wherein:
the first and second transistors are NMOS device structures;
the dipole dopant is an N-dipole dopant; and
the second gate insulator comprises more of the dipole dopant than the first gate insulator.

3. The SRAM bit-cell structure of claim 2, wherein;
the first metal species is a first of Hf, Al, Zr, or Y; and
the second metal species is Mg, Ca, Sr, La, Sc, Ba, Gd, Er, Yb, Lu, Ga, Mo, Co, Ni, Nb, or a second of Hf, Al, Zr, or Y.

4. The SRAM bit-cell structure of any one of claims 2-3, wherein:
within the second gate insulator, a ratio of a concentration of the second metal species to a concentration of the first metal species is between 0.1 and 0.2; and
within the second gate insulator, a ratio of a concentration of the second metal species to a concentration of the first metal species is between 0 and 0.1.

5. The SRAM bit-cell structure of any one of claims 2-4, wherein the first gate insulator also comprises the dipole dopant but at a lower concentration than that of the second gate insulator.

6. The SRAM bit-cell structure of any one of claims 2-5, wherein the dipole dopant is absent from the first gate insulator.

7. The SRAM bit-cell structure of any one of claims 1-6, wherein:
the first and second transistors are NMOS device structures
the dipole dopant is an P-dipole dopant; and
the second gate insulator comprises less of the dipole dopant than the first gate insulator.

8. The SRAM bit-cell structure of any one of claims 1-7, wherein the first transistor is a pass-gate transistor, the second transistor is a pull-down transistor and the SRAM bit-cell structure further comprises a pair of pull-up transistors, and wherein each of the pull-up transistors further comprises:
a third stack of nanoribbons;
a third gate electrode around a channel region of the third stack of nanoribbons; and
a third gate insulator between the third gate electrode and the channel region of the third stack of nanoribbons, wherein the third gate insulator comprises the high-k gate material layer and lacks the dipole dopant.

9. The SRAM bit-cell structure of any one of claims 1-8, wherein:
the first stack of nanoribbons and the second stack of nanoribbons have substantially the same composition;
the first gate electrode and the second gate electrode have substantially the same composition;
the first transistor has a first threshold voltage; and
the second transistor has a second threshold voltage, different than the first threshold voltage.

10. The SRAM bit-cell structure of claim 9, wherein a magnitude of the first threshold voltage is higher than the magnitude of the second threshold voltage.

11. A device comprising:
a microprocessor comprising:
an arithmetic logic unit; and
a cache memory comprising an SRAM array, wherein the SRAM array comprises a plurality of bit-cells and each bit cell comprises:
the first and second transistors of any one of claims 1-10; and
a power supply coupled to power the microprocessor.

12. The device of claim 11, further comprising a battery coupled to the power supply.

13. A method of fabricating a static random-access memory (SRAM) structure, the method comprising:
forming a transistor material stack including a plurality of bilayers comprising sacrificial material and channel material;
patterning the transistor material stack into a fin;
forming a first gate insulator comprising a first metal species and a first amount of second metal species around a pull-down transistor region of the channel material;
forming a second gate insulator comprising the first metal species and a second amount of the second metal species, different than the first amount, around a pass-gate transistor region of the channel material;
forming a gate electrode material around the first gate insulator; and
forming the gate electrode material around the second gate insulator.

14. The method of claim 13, wherein forming the first gate insulator and the second gate
insulator comprises:
forming a gate insulator material including an N-dipole dopant source material comprising the second metal species around the pull-down and pass-gate transistor regions;
removing more of the N-dipole dopant source material from the pass-gate transistor region than from the pull-down transistor region; and
thermally annealing the structure.

15. The method of claim 14, further comprising:
removing substantially all of the N-dipole dopant source material from the pull-down transistor region; and
depositing the gate electrode material.
